(19) Europäisches Patentamt
European Patent Office
Office européen des brevets

(11) **EP 3 433 123 B1**

(12) **EUROPÄISCHE PATENTSCHRIFT**

(45) Veröffentlichungstag und Bekanntmachung des Hinweises auf die Patenterteilung:
**02.12.2020  Patentblatt 2020/49**

(51) Int Cl.:
**B60K 37/06** (2006.01)   **B60K 35/00** (2006.01)
**G06F 3/01** (2006.01)

(21) Anmeldenummer: **17712456.7**

(22) Anmeldetag: **20.03.2017**

(86) Internationale Anmeldenummer:
**PCT/EP2017/056555**

(87) Internationale Veröffentlichungsnummer:
**WO 2017/162586 (28.09.2017 Gazette 2017/39)**

(54) **BEDIENEINHEIT FÜR EIN GERÄT, INSBESONDERE FÜR EINE FAHRZEUGKOMPONENTE**

OPERATING UNIT FOR A DEVICE, IN PARTICULAR FOR A VEHICLE COMPONENT

UNITÉ DE COMMANDE D'UN APPAREIL, EN PARTICULIER D'UN COMPOSANT DE VÉHICULE AUTOMOBILE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **23.03.2016  DE 102016204875**

(43) Veröffentlichungstag der Anmeldung:
**30.01.2019  Patentblatt 2019/05**

(73) Patentinhaber: **Behr-Hella Thermocontrol GmbH**
**70469 Stuttgart (DE)**

(72) Erfinder:
• **PANKRATZ, Harri**
**59505 Bad Sassendorf (DE)**
• **BANDLOW, Bastian**
**33100 Paderborn (DE)**
• **BESCHNITT, Alexander**
**33332 Gütersloh (DE)**
• **VOGT, Frank**
**33165 Lichtenau-Husen (DE)**

(74) Vertreter: **dompatent von Kreisler Selting Werner - Partnerschaft von Patent- und Rechtsanwälten mbB**
**Deichmannhaus am Dom**
**Bahnhofsvorplatz 1**
**50667 Köln (DE)**

(56) Entgegenhaltungen:
**DE-A1-102008 046 102     US-A1- 2004 075 676**

**Beschreibung**

Die Erfindung betrifft eine Bedieneinheit für ein Gerät, bei dem es sich insbesondere um eine Fahrzeugkomponente handelt. Insbesondere betrifft die Erfindung Bedieneinheiten mit Kräftekompensation bei einem durch mechanische Anregung eines Bedienelements der Bedieneinheiten erfolgenden aktiven haptischen Feedback, so dass in Folge des aktiven haptischen Feedback auftretende Schwingungen des Bedienelements ausgeglichen bzw. zumindest gedämpft werden und sich somit nicht auf die Umgebung der Bedieneinheit (z.B. Instrumententafel) nicht oder nur gedämpft auswirken.

Display-Baugruppen in Kraftfahrzeugen werden oftmals mit einem aktiven haptischen Feedback ausgerüstet, um dem Benutzer eine Bedieneingabe insbesondere taktil zu bestätigen. Dabei soll das Auslösen des Feedbacks keine unzulässige dynamische Kraftübertragung auf die Bedieneinheitumgebung wie z.B. eine Instrumententafel bzw. auf ein Fahrzeug erzeugen, da diese je nach Einbausituation zu parasitären Geräuschen bzw. Vibrationen im Fahrzeug führen kann. Eine solche mechanische Entkopplung ist um so wichtiger, je größer die Masse des mechanisch angeregten Bedienelements ist.

Desweiteren soll das haptische Feedback weitgehend unabhängig von der Elastizität der Befestigung im Fahrzeug sein.

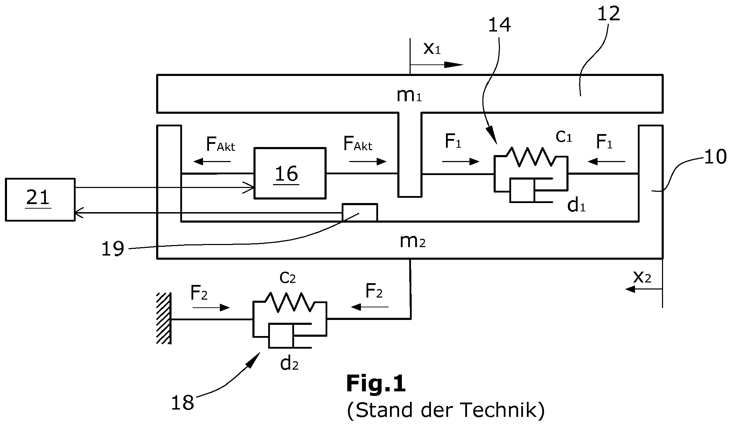

Ein mit einem aktiven haptischen Feedback ausgestattetes Gerät besteht im Wesentlichen aus einem Bedienelement mit Bedienfeld (z.B. Touchscreen oder Display), das über ein Federsystem am Gerätegehäuse elastisch befestigt ist, einem Aktuator zur Auslenkung des Bedienelements und einem Gehäuse, das im Fahrzeug fest verbaut wird. In Fig. 1 sind die wirkenden Kräfte in einem solchen Geräteaufbau dargestellt. Mit 10 ist das Gehäuse mit der Masse $m_2$ bezeichnet. Die Anbindung bzw. Befestigung des Gehäuses 10 an die Geräteumgebung (beispielsweise Instrumententafel) ist durch das Feder-Dämpfungs-System 18 symbolisiert. Der Aktuator ist mit 16 bezeichnet und regt das Display bzw. Bedienelement 12 mit der Masse $m_1$ mechanisch an. Das bewegbar gelagerte Bedienelement 12 ist federelastisch am Gehäuse 10 gelagert, was durch das Feder-Dämpfungs-System 14 symbolisiert ist. Ein Sensor 19 erkennt eine Betätigung des Bedienelements 12 (Force-Sense-Funktion) und gibt ein Signal an die Auswerte- und Ansteuereinheit 21 weiter, die den Aktuator 16 ansteuert (Force-Feedback-Funktion).

Zur Erzeugung des haptischen Feedbacks wird das Display mit einem bestimmten Wegverlauf $x_1(t)$ aus seiner Ruhelage ausgelenkt. Die Displaybeschleunigung $a_1(t)$ kann hierbei Werte von mehr als 30 m/s$^2$ annehmen, was bei einer bewegten Displaymasse $m_1$ von über 0,5 kg und einer in der Regel kleinen Gehäusemasse $m_2$ zu einer nicht zu vernachlässigenden dynamischen Kraft $F_2(t)$ auf die Gerätebefestigung im Fahrzeug führt.

Bei einer "steifen" Gerätehalterung bzw. -befestigung an z.B. der Instrumententafel (steifes Federsystem $c_2$, $d_2$) kann diese zeitlich schnell veränderliche Kraft unzulässige Geräusche bzw. Vibrationen im Fahrzeug verursachen.

Bei einer "weichen" Befestigung des Gehäuses (weiches Federsystem $c_2$, $d_2$) dagegen erweist sich das Einhalten von Einbautoleranzen des Geräts im Fahrzeug als schwierig. Fernerhin ist die Abstimmung des erforderlichen Aktuatorkraftverlaufs $F_{Akt}(t)$ durch das Vorhandensein eines weiteren Freiheitsgrades, nämlich der Gehäusebewegung $x_2(t)$ und somit auch zusätzlicher Eigenfrequenzen im System, unter Umständen nicht möglich.

Aus US-A-2004/0075676 ist eine Bedieneinheit und im Speziellen ein Laptop mit Haptik-Feedback für das Touchpad des Laptops bekannt. Das Touchpad wird dabei durch einen Piezo-Aktuator mechanisch angeregt und ist seinerseits federnd am Gehäuse des Laptops gelagert. Am Piezo-Aktuator ist ein Gegengewicht hängend angeordnet, das auf Grund der Ausdehnung des Piezo-Aktuators bei dessen Ansteuerung entgegengesetzt zur Bewegung des Touchpad verschoben wird. Mit dieser Lösung allerdings lassen sich ein Impulsausgleich und eine Kompensation der dynamischen Kräfte innerhalb des Gehäuses des Laptops nicht so ohne weiteres realisieren.

Weiterhin offenbart auch US-A-2011/0276878 eine Bedieneinheit.

Aufgabe der Erfindung ist es, ein hinsichtlich der Entstehung von parasitären Geräuschen bzw. Vibrationen verbessertes Konzept für eine Bedieneinheit mit aktivem haptischen Feedback zu schaffen.

Zur Lösung dieser Aufgabe wird mit der Erfindung eine Bedieneinheit für ein Gerät, z. B. für eine Fahrzeugkomponente, insbesondere Mensch-Maschine-Interface (MMI bzw. HMI) vorgeschlagen, wobei die Bedieneinheit versehen ist mit den Merkmalen des Anspruchs 1. Einzelne Ausgestaltungen der Erfindung sind Gegenstand der Unteransprüche.

Nach der Erfindung ist also das Ausgleichsgewicht elastisch an das Gehäuse angebunden. Das Ausgleichsgewicht wird entweder durch den das Bedienelement anregenden Aktuator oder durch einen separaten Aktuator, der dem Ausgleichsgewicht zugeordnet ist, bewegt.

Erfindungsgemäß ist das Ausgleichsgewicht als Teil des das Bedienelement mechanisch anregenden Aktuators, z.B. als integraler Bestandteil des Stators eines Zuganker- oder Tauchspulenelektromagnet-Aktuators ausgebildet. In jedem Fall ist das Ausgleichsgewicht elastisch an das Gehäuse gelagert und insoweit elastisch gegenüber dem Gehäuse abgestützt.

Insbesondere von Vorteil ist es, wenn das Ausgleichsgewicht um im Wesentlichen 180° phasenverschoben und damit gegensinnig zur Anregungsbewegung des Bedienfelds bewegbar ist, wobei der Bewegungshub des Ausgleichsgewichts unter Berücksichtigung zumindest der Relation der Masse des Bedienelements zur Masse des Ausgleichsgewichts gewählt ist. Beträgt beispielsweise die Masse des Ausgleichsgewichts die Hälfte der Masse des Bedienelements, so ist der Bewegungshub des Ausgleichsgewichts doppelt so groß wie der Bewegungshub des Bedienelements. In der Praxis wird das Bedienelement beispielsweise um 0,1 mm bzw. um wenige 1/10 mm ausgelenkt. Beträgt die Masse des Bedienelements beispielsweise 0,5 kg, so könnte beispielsweise für die erfindungsgemäße Kompensation von von der Bedieneinheit nach außen wirksamen Kräfte ein Ausgleichsgewicht mit einer Masse von 50 g und einem Bewegungshub von 1 mm bzw. einige wenige mm verwendet werden.

Für die möglichst vollständige Kräftekompensation ist es von Vorteil, dass die Eigenfrequenzen des Feder-Masse-Dämpfungssystems der elastischen Anbindung des Bedienelements am Gehäuse einerseits und die Eigenfrequenz des Feder-Masse-Dämpfungssystems der elastischen Anbindung des Ausgleichgewichts am Gehäuse bzw. am Bedienelement gleich sind bzw. im Wesentlichen gleich sind. Dabei wird im Rahmen der Erfindung unter "im Wesentlichen gleich" eine Eigenfrequenzabweichung von 50 %, insbesondere 40 %, vorzugsweise 30 % und besonders vorzugsweise 20 % bzw. 10 % angesehen.

Die erfindungsgemäße Bedieneinheit kann insbesondere als Anzeige- und Bedieneinheit ausgebildet sein.

Die Erfindung wird nachfolgend anhand eines Ausführungsbeispiels sowie unter Bezugnahme auf die Zeichnung näher erläutert. Im Einzelnen zeigen dabei:

Fig. 1    schematisch die bei einer Bedieneinheit mit aktivem haptischen Feed-back nach dem Stand der Technik auftretenden Kräfte,

Fig. 2    eine schematische Darstellung der auftretenden Kräfte bei erfindungsgemäßer Verwendung eines Gegengewichts als Ausgleichsmasse und

Fig. 3    schematisch eine Konstruktion eines gegenkraftfreien haptischen Feedback bei einer Bedieneinheit.

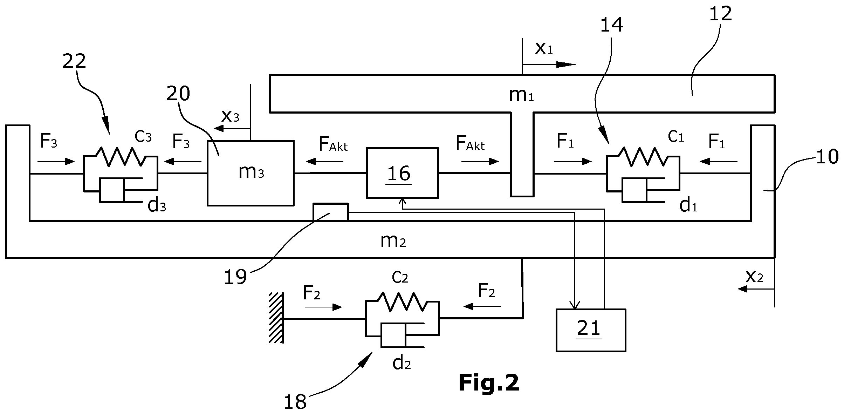

Erfindungsgemäß wird die Verwendung einer elastisch gelagerten (siehe Feder-Masse-Dämpfungssystem 22) beweglichen Gegenmasse 20 zwischen dem Aktuator 16 und dem Gehäuse 10 zum Ausgleich der auf das Gehäuse 10 wirkenden Kräfte vorgeschlagen (Fig. 2). Die Betätigung des Bedienelements 12 wird mittels des Betätigungssensors 19 erkannt. Daraufhin wird über eine Auswerte- und Ansteuereinheit 21, die Signale vom Betätigungssensor 19 empfängt und Ansteuersignale an den Aktuator 16 sendet, der Aktuator 16 angesteuert.

Bei entsprechender Auslegung des zusätzlichen Feder-Masse-Dämpfungssystems 22 bzw. $c_3$, $d_3$, $m_3$ kann die auf das Fahrzeug wirkende, resultierende Kraft $F_2(t)$ eliminiert werden (die durch Gravitation entstehenden statischen Kräfte spielen bei der Entstehung von Geräuschen bzw. Vibrationen keine Rolle).

Für eine beliebig vorgegebene Displayauslenkung $x_1(t)$ kann die Auslenkung $x_2(t)$/Bewegung des Gerätegehäuses und somit auch die Kraft $F_2(t)$ auf die Gerätebefestigung unter folgenden Bedingungen eliminiert werden:

$$c_3 = c_1 \frac{m_3}{m_1}, \qquad d_3 = d_1 \frac{m_3}{m_1}$$

Daraus ergibt sich die Auslenkung der Gegenmasse 20:

$$x_3(t) = x_1(t) \frac{m_1}{m_3}$$

Unter diesen Bedingungen hat auch die Elastizität der Gerätebefestigung 18 keinen Einfluss auf das haptische Feedback. Die Gegenmasse 20 bzw. $m_3$ ist in der Regel durch die Bauraumvorgaben eingeschränkt und ist kleiner als die Displaymasse $m_1$. Idealerweise kann sie als ein Teil des Aktuators 16 ausgeführt werden.

Die vorliegende Erfindung ermöglicht es

- ein haptisches Feedback auf massebehafteten Oberflächen ohne dynamische Krafteinwirkung auf die Umgebung zu erzeugen.
- ein haptisches Feedback in einem Bediengerät zu erzeugen, das unabhängig von der Elastizität der Gerätebefestigung ist.

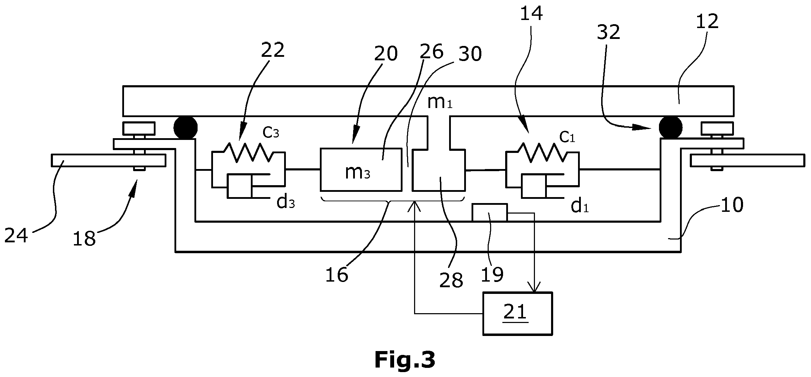

In Fig. 3 ist eine Vorrichtung mit einem gegenkraftfreien haptischen Feedback skizziert.

Im dargestellten Beispiel ist der Aktuator 20 als Zugankerelektromagnet ausgebildet und weist ein am Gehäuse 10 elastisch gelagertes Statorblechpaket mit Aktuatorspule, d.h. einen Stator 26 und einem am Bedienelement 12 fest angebundenes Ankerblechpaket, d. h. einen Anker 28 auf. Der Stator 26 bildet die bewegliche Gegenmasse 20 bzw. weist diese auf. Bei der Einstellung des bei 30 gezeigten Luftspalts im Zugankerelektromagnet muss die maximale Auslenkung des Displays 10 und der Gegenmasse 20 zueinander berücksichtigt werden. Der Stator 26 ist elastisch (Feder-Masse-Dämpfungssystem 22) am Gehäuse 10 gelagert, kann aber auch stattdessen am Bedienelement 12 elastisch angebunden sein. Die Bedienelementführung ist bei 32 angedeutet. Das Gehäuse 10 ist am Fahrzeug 24 (z.B. an dessen Instrumententafel) befestigt.

Die Erfindung wurde vorstehend anhand einer Fahrzeug-Bedieneinheit beschrieben, gilt aber, wie eingangs erwähnt, ganz allgemein für Bedieneinheiten von Geräten bzw. Anlagen sämtlicher Art. Dabei ist bei Geräten, die über mehr als eine mit haptischem Feedback versehene Bedienoberfläche verfügen, jede Bedienoberfläche unabhängig von der mindestens einen anderen Bedienoberfläche mechanisch in der Weise anregbar, wie es die Erfindung vorsieht. Jede Bedienoberfläche verfügt also über eine ihr zugeordnete Ausgleichsmasse, um nach außen hin wirkende Gerätekräfte und -bewegungen, die durch die mechanische Anregung einer der Bedienoberflächen induziert werden, kompensieren zu können.

## BEZUGSZEICHENLISTE

| 10 | Gehäuse |
|----|---------|
| 12 | Bedienelement |
| 14 | Feder-Dämpfungssystem der elastischen Anbindung des Bedienelements am Gehäuse |
| 16 | Aktuator |
| 18 | Feder-Dämpfungssystem der (elastischen) Anbindung des Gehäuses ans Fahrzeug |
| 19 | Betätigungssensor |
| 20 | Gegengewicht |
| 21 | Auswerte- und Ansteuereinheit |
| 22 | Feder-Dämpfungssystem der elastischen Anbindung des Gegengewichts am Gehäuse und/oder am Bedienelements |
| 24 | Fahrzeug bzw. Instrumententafel des Fahrzeugs |
| 26 | Stator des als Aktuator ausgeführten Zugankerelektromagnets |
| 28 | Anker des Zugankerelektromagnets |
| 30 | Luftspalt des Zugankerelektromagnets |
| 32 | Bedienfeldführung für die Bewegung bei haptischer Rückmeldung |
| $m_1$ | Masse des Bedienfelds |
| $x_1(t)$ | Auslenkung des Bedienfelds |
| $F_{Akt}(t)$ | Aktuatorkraftverlauf |
| $F_1(t)$ | auf das Gehäuse 10 wirkende Kraft des Bedienfelds bei Anregung desselben ($F_1(t) = F_{Akt} - m_1 x\ a_1$) |
| $c_1$ | Federkonstante der elastischen Anbindung des Bedienfelds am Gehäuse |
| $d_1$ | Dämpfung der elastischen Anbindung des Bedienfelds am Gehäuse |
| $m_2$ | Masse des Gehäuses |
| $x_2(t)$ | Auslenkung des Gehäuses in Folge der durch das mechanisch angeregte Bedienfeld ausgeübten Kraft |
| $F_2(t)$ | auf die Gehäusebefestigung wirkende Kraft |
| $m_3$ | Masse des Gegengewichts |
| $x_3(t)$ | Auslenkung des Gegengewichts |
| $F_3$ | durch das Gegengewicht auf das Gehäuse wirkende Kraft |
| $c_3$ | Federkonstante der elastischen Anbindung des Gegengewichts am Gehäuse |
| $d_3$ | Dämpfung der elastischen Anbindung des Ge- |

gengewichts am Gehäuse

## Patentansprüche

1. Bedieneinheit für ein Gerät, z.B. für eine Fahrzeugkomponente, insbesondere Mensch-Maschine-Interface (MMI bzw. HMI), mit

   - einem Gehäuse (10), das ein Bedienelement (12) mit einem Bedienfeld, wie z.B. ein Touchscreen oder Touchpad oder Display aufweist und zur Befestigung in einer Vorrichtung, insbesondere einer Fahrzeug-Instrumententafel oder Fahrzeug-Mittelkonsole vorgesehen ist,
   - wobei das Bedienelement (12) elastisch an dem Gehäuse (10) gelagert ist,
   - einem Sensor (19) zur Erkennung einer Bedienung des Bedienelements (12),
   - einem Aktuator (16) zur bei Erkennung einer Bedienung des Bedienelements (12) erfolgenden mechanischen Anregung des Bedienfelds (12) und
   - einem Ausgleichsgewicht (20),
   - wobei das Ausgleichsgewicht (20) elastisch im und/oder am Gehäuse (10) gelagert ist und
   - wobei das Ausgleichsgewicht (20) bei Erkennung einer Bedienung des Bedienelements (12) von dem oder von einem Aktuator (16) mechanisch anregbar und zum im Wesentlichen Ausgleichen einer Bewegung des Gehäuses (10) bei Aktivierung des das Bedienelement (12) mechanisch anregenden Aktuators (16) bewegbar ist,
   **dadurch gekennzeichnet,**
   - **dass** das Bedienelement (12) inklusive seiner elastischen Anbindung an das Gehäuse (10) und das Ausgleichsgewicht (20) inklusive seiner elastischen Anbindung an das Gehäuse (10) jeweils eine Eigenfrequenz aufweist, wobei beide Eigenfrequenzen gleich oder im Wesentlichen gleich sind,
   - **dass** der Aktuator (16) als ein Zuganker- oder ein Tauchspulenelektromagnet mit einem Stator (26) und einem Anker (28) ausgebildet ist, wobei der Anker (28) - oder alternativ der Stator (26) - mit dem Bedienelement (12) und der Stator (26) - oder alternativ der Anker (28) - mit der Ausgleichsmasse (20) kinematisch gekoppelt ist, und
   - **dass** der mit der Ausgleichsmasse (20) kinematisch gekoppelte Stator (26) - oder alternativ Anker (28) - die Ausgleichsmasse (20) bildet und/oder aufweist.

2. Bedieneinheit nach Anspruch 1, **dadurch gekennzeichnet, dass** das Ausgleichsgewicht (20) als Teil des das Bedienelements (12) mechanisch anregenden Aktuators (16) ausgebildet ist.

3. Bedieneinheit nach Anspruch 1 oder 2, **dadurch gekennzeichnet, dass** das Ausgleichsgewicht (20) um im Wesentlichen 180° phasenverschoben und damit gegensinnig zur Anregungsbewegung des Bedienelements (12) bewegbar ist, wobei der Bewegungshub des Ausgleichsgewichts (20) unter Berücksichtigung zumindest der Relation der Masse des Bedienelements (12) zur Masse des Ausgleichsgewichts (20) gewählt ist.

4. Bedieneinheit nach einem der Ansprüche 1 bis 3, **dadurch gekennzeichnet, dass** die Bedieneinheit als Anzeige- und Bedieneinheit ausgebildet ist und das Bedienelement (12) neben einer Bedienfunktion auch eine Anzeigefunktion aufweist.

**Claims**

1. An operating unit for a device, e.g. for a vehicle component, particularly a man-machine interface (MMI or HMI), comprising

   - a housing (10) which comprises an operating element (12) having an operating panel such as e.g. a touchscreen or touchpad or display, and which is provided for attachment in a device, particularly in a vehicle dashboard or vehicle center console,
   - wherein the operating element (12) is elastically mounted on the housing (10),
   - a sensor (19) for detection of an actuation of the operating element (12),
   - an actuator (16) for mechanical excitation of the operating panel (12) occurring upon detection of an actuation of the operating element (12), and
   - a compensating weight (20),
   - wherein the compensating weight (20) is elastically supported in and/or on the housing (10), and
   - wherein the compensating weight (20) is adapted to be mechanically excited by said, or an, actuator (16) upon detection of an actuation of the operating element (12), and is movable to substantially compensate a movement of the housing (10) upon activation of the actuator (16) mechanically exciting the operating element (12),
   **characterized in**
   - **that** the operating element (12) inclusive of its elastic mounting to the housing (10) and the compensating weight (20) inclusive of its elastic mounting to the housing (10) each have a natural frequency, wherein both natural frequencies are equal or substantially equal,
   - **that** the actuator (16) is designed as a tie-rod or plunger-coil electromagnet comprising a stator (26) and an armature (28), wherein the armature (28) - or alternatively the stator (26) - is kinematically coupled to the operating element (12), and the stator (26) - or alternatively the armature (28) - is kinematically coupled to the compensating weight (20), and
   - **that** the stator (26) kinematically coupled to the compensating weight (20) - or alternatively the armature (28) - forms and/or comprises the compensating weight (20).

2. The operating unit according to claim 1, **characterized in that** the compensating weight (20) is designed as a part of the actuator (16) mechanically exciting the operating element (12).

3. The operating unit according to claim 1 or 2, **characterized in that** the compensating weight (20) is movable with a phase shift of substantially 180° and thus in the opposite direction to the excitation movement of the operating element (12), wherein the movement stroke of the compensating weight (20) is selected under consideration of at least the relation of the mass of the operating element (12) to the mass of the compensating weight (20).

4. The operating unit according to one of claims 1 to 3, **characterized in that** the operating unit is designed as a display and operating unit and wherein the operating element (12) comprises, apart from an operating function, also a display function.

**Revendications**

1. Unité de commande pour un appareil, par exemple pour un composant de véhicule, en particulier une interface homme-machine (IHM), dotée

   - d'un boîtier (10), lequel comporte un élément de commande (12) doté d'un champ de commande comme par exemple un écran tactile ou une surface tactile ou un écran, et lequel est prévu pour être fixé dans un dispositif, en particulier un tableau de bord de véhicule ou une console centrale de véhicule,
   - dans laquelle l'élément de commande (12) est disposé élastiquement sur le boîtier (10),
   - d'un capteur (19) permettant de reconnaître une commande de l'élément de commande (12),
   - d'un actionneur (16) permettant une excitation mécanique subséquente du champ de commande (12) lorsqu'une commande de l'élément de commande (12) est reconnue et
   - d'un contrepoids (20),

- dans laquelle le contrepoids (20) est disposé élastiquement dans et/ou sur le boîtier (10) et

- dans laquelle le contrepoids (20) est mécaniquement excitable par le ou par un actionneur (16) lorsqu'une commande de l'élément de commande (12) est reconnue et est mobile afin de compenser sensiblement un mouvement du boîtier (10) lors de l'activation de l'actionneur (16) excitant mécaniquement l'élément de commande (12),

**caractérisée**

- **en ce que** l'élément de commande (12), y compris son raccordement élastique sur le boîtier (10), et le contrepoids (20), y compris son raccordement élastique sur le boîtier (10), présentent respectivement une fréquence propre, dans laquelle les deux fréquences propres sont égales ou sensiblement égales,

- **en ce que** l'actionneur (16) est réalisé comme un électro-aimant à armature de traction ou à bobine mobile doté d'un stator (26) et d'une armature (28), dans laquelle l'armature (28) ou alternativement le stator (26) est couplée cinématiquement à l'élément de commande (12) et le stator (26) ou alternativement l'armature (28) est couplé cinématiquement au contrepoids (20), et

- **en ce que** le stator (26), ou alternativement l'armature (28), couplé cinématiquement au contrepoids (20) forme et/ou comporte le contrepoids (20).

2. Unité de commande selon la revendication 1, **caractérisée en ce que** le contrepoids (20) est réalisé comme partie de l'actionneur (16) excitant mécaniquement l'élément de commande (12).

3. Unité de commande selon la revendication 1 ou 2, **caractérisée en ce que** le contrepoids (20) est déphasé de sensiblement 180° et est donc mobile à l'opposé du mouvement d'excitation de l'élément de commande (12), dans laquelle la course du contrepoids (20) est choisie en tenant compte au moins du rapport de la masse de l'élément de commande (12) à la masse du contrepoids (20) .

4. Unité de commande selon l'une des revendications 1 à 3, **caractérisée en ce que** l'unité de commande est réalisée comme unité de commande et d'affichage et l'élément de commande (12) comporte une fonction d'affichage en sus d'une fonction de commande.

**Fig.1**
(Stand der Technik)

**Fig.2**

EP 3 433 123 B1

Fig.3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20040075676 A
- US 20110276878 A